# FASCICULE DE BREVET EUROPEEN

(11) **EP 4 135 007 B1**
(45) Date de publication et mention de la délivrance du brevet: **23.09.2026**
(21) Numéro de dépôt: 22188356.4
(22) Date de dépôt: 02.08.2022
(51) Int. Cl.: H10P 95/00, H10W 10/00

(54) **PROCÉDÉ DE FABRICATION DE COMPOSANTS RADIOFRÉQUENCE**
VERFAHREN ZUR HERSTELLUNG VON HOCHFREQUENZKOMPONENTEN
METHOD FOR MANUFACTURING RADIOFREQUENCY COMPONENTS

(30) Priorité: 12.08.2021 FR 2108655
(43) Date de publication de la demande: 15.02.2023
(73) Titulaire: STMicroelectronics (Tours) SAS, 37100 Tours (FR)
(72) Inventeur: HAUTTECOEUR, Patrick, 37540 SAINT CYR SUR LOIRE (FR)
(74) Mandataire: Cabinet Beaumont

(56) Documents cités:
- US-A1- 2003 218 171
- US-A1- 2019 057 868
- US-A1- 2020 161 336
- US-A1- 2021 183 690
- US-B2- 11 081 407

## Description

### Domaine technique

La présente description concerne le domaine des composants électroniques de façon générale. Elle vise plus particulièrement le domaine des composants radiofréquence.

### Technique antérieure

On appelle généralement composants radiofréquence des composants dont la fréquence de fonctionnement est comprise dans la plage allant de 3 kHz à 30 GHz. Parmi les composants radiofréquence connus, on trouve des composants actifs comme les amplificateurs, les mélangeurs et les convertisseurs de données, et des composants passifs comme les condensateurs, les inductances et les antennes. Les documents US202/161336 et US2019/057868 décrivent des procédés de fabrication de dispositifs radiofréquence sur un substrat semiconducteur dans le quel une couche isolante est fabriquée, puis un recuit laser est réalisé.

### Résumé de l'invention

Il existe un besoin d'amélioration des composants radiofréquence connus et de leurs procédés de fabrication.

Un mode de réalisation prévoit un procédé de fabrication d'un dispositif comportant au moins un composant radiofréquence sur un substrat semiconducteur comprenant les étapes décrites dans la revendication 1.

Selon un mode de réalisation, le substrat a une résistivité supérieure à 3 kΩ.cm.

Selon un mode de réalisation, le procédé comprend, avant l'étape a), une étape de formation d'une couche d'oxyde du côté de la face supérieure du substrat.

Selon un mode de réalisation, la puissance du laser lors de l'étape a) est de l'ordre de 4j/cm².

Selon un mode de réalisation, le substrat est en silicium ou en nitrure de gallium.

Selon un mode de réalisation, le laser a une longueur d'onde comprise entre 300 nm et 700 nm.

Selon un mode de réalisation, lors de l'étape a), la première épaisseur du substrat est fondue.

Selon un mode de réalisation, l'étape a) est suivie d'une étape de refroidissement du substrat.

Selon un mode de réalisation, la première épaisseur est comprise entre 0,5 µm et 2 µm, par exemple, de l'ordre de 1 µm.

Selon un mode de réalisation, ledit au moins un composant radiofréquence est un composant passif en un matériau métallique disposé sur et en contact avec la face supérieure de la couche isolante.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en coupe illustrant un exemple de dispositif comprenant des composants radiofréquence ;
la figure 2 est une vue en coupe illustrant une structure obtenue à l'issue d'une étape d'un exemple d'un procédé de fabrication d'un dispositif comprenant des composants radiofréquence selon un mode de réalisation ;
la figure 3 est une vue en coupe illustrant une structure obtenue à l'issue d'une autre étape d'un exemple d'un procédé de fabrication d'un dispositif comprenant des composants radiofréquence selon un mode de réalisation ;
la figure 4 est une vue en coupe illustrant une structure obtenue à l'issue d'une autre étape d'un exemple d'un procédé de fabrication d'un dispositif comprenant des composants radiofréquence selon un mode de réalisation ;
la figure 5 est une vue en coupe illustrant une structure obtenue à l'issue d'une autre étape d'un exemple d'un procédé de fabrication d'un dispositif comprenant des composants radiofréquence selon un mode de réalisation ; et
la figure 6 est une vue en coupe illustrant une structure obtenue à l'issue d'une autre étape d'un exemple d'un procédé de fabrication d'un dispositif comprenant des composants radiofréquence selon un mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, la réalisation des composants radiofréquence n'a pas été détaillée, la réalisation de ces composants étant à la portée de la personne du métier à partir des indications de la présente description. En outre, les applications dans lesquelles de tels composants sont susceptibles d'être utilisés n'ont pas été détaillées, les modes de réalisation décrits étant compatible avec les applications usuelles des composants radiofréquence.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

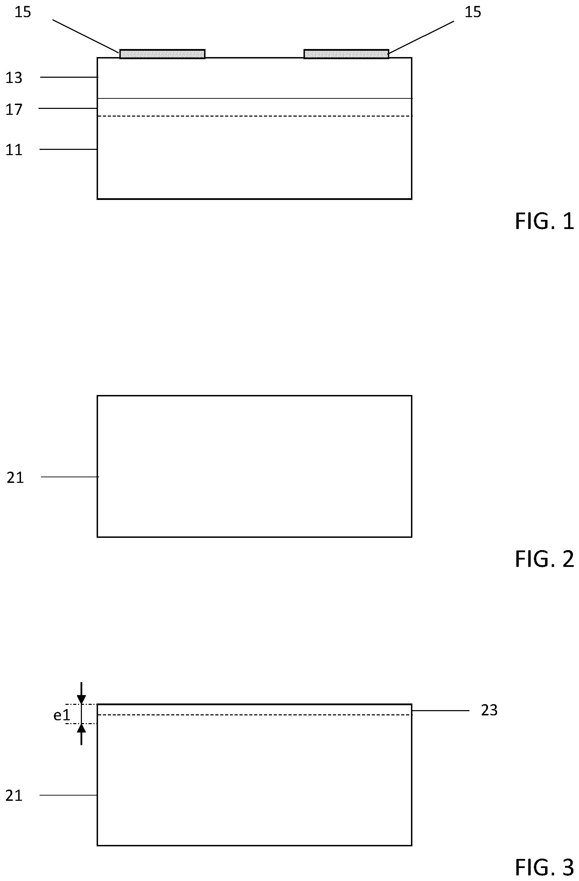

La figure 1 est une vue en coupe illustrant un exemple de dispositif comprenant des composants radiofréquence 15.

Le dispositif illustré en figure 1 comprend un substrat semiconducteur 11 revêtu par une couche de passivation 13, sur laquelle sont disposés les composants radiofréquence 15. La couche de passivation 13 est par exemple, en contact, par sa face inférieure, avec la face supérieure du substrat semiconducteur 11. La couche de passivation 13 s'étend par exemple de façon continue sur toute la surface du substrat semiconducteur 11. Dans l'exemple illustré en figure 1, le dispositif comprend deux composants radiofréquence 15. En pratique, le dispositif peut comporter un nombre quelconque de composants radiofréquence 15, par exemple un unique composant radiofréquence 15 ou plus de deux composants radiofréquence 15.

Le substrat 11 correspond par exemple à une plaquette semiconductrice ou à un morceau de plaquette semiconductrice. Le substrat 11 est par exemple en silicium ou en nitrure de gallium (GaN). A titre d'exemple, le substrat 11 est en un matériau à haute résistivité, par exemple un matériau dont la résistivité est supérieure à 3 kΩ.cm. Le substrat 11 est par exemple en silicium de haute résistivité. Le substrat 11 peut être un substrat semiconducteur massif, par exemple un substrat en silicium de haute résistivité massif, ou un substrat de type SOI (de l'anglais "Semiconductor On Insulator" - semiconducteur sur isolant), par exemple un substrat en silicium de haute résistivité sur isolant.

La couche de passivation 13 est une couche isolante électriquement. La couche de passivation 13 est par exemple en dioxyde de silicium.

En pratique, du fait des hautes fréquences de fonctionnement des composants radiofréquence 15, des courants induits peuvent apparaître dans une partie supérieure 17 du substrat 11, appelée zone de conduction parasite de surface (PSC, de l'anglais "Parasitic Surface Conduction"). Ces courants induits peuvent perturber le bon fonctionnement des composants radiofréquence 15 et dégrader leurs performances.

Selon un mode de réalisation, on prévoit de former une couche riche en pièges dans une partie supérieure du substrat 11. En effet, la présence de pièges permet de dégrader la mobilité des électrons et des trous, ce qui permet de réduire les courants induits qui sont à l'origine de la dégradation de performances des composants RF.

Il a déjà été proposé de former une couche superficielle riche en pièges dans un substrat semiconducteur par diverses techniques et notamment par texturation laser, par gravure chimique, par irradiation électronique, par formation de nano-cavitées, par contrainte thermique ou par texturation mécanique. Pour augmenter la densité en pièges, plusieurs de ces techniques peuvent par exemple être combinées. Il serait souhaitable de pouvoir disposer d'une technique alternative, plus simple à mettre en oeuvre, pour former une couche superficielle riche en pièges dans un substrat semiconducteur destiné à supporter des composants radiofréquence.

Dans le mode de réalisation décrit ci-après, on prévoit de créer une couche riche en pièges en utilisant une technique de recuit laser. Cette technique, utilisée habituellement pour activer ou propager des dopants dans une couche semiconductrice, est dans ce mode de réalisation utilisée de façon inhabituelle, pour créer volontairement des défauts dans une couche semiconductrice.

Les figures 2 à 6 sont des vues en coupe illustrant des étapes successives d'un exemple d'un procédé de fabrication d'un dispositif comprenant des composants radiofréquence selon un mode de réalisation.

La figure 2 illustre une structure de départ composée d'un substrat semiconducteur 21. Le substrat 21 est par exemple une plaquette ou tranche en un matériau semiconducteur. A titre d'exemple, le substrat 21 est en silicium ou en nitrure de gallium. A titre d'exemple, le substrat 21 est en un matériau de haute résistivité. Le substrat 21 peut être un substrat semiconducteur massif, ou un substrat de type SOI.

Le substrat 21 a par exemple une épaisseur comprise entre 300 µm et 800 µm, par exemple de l'ordre de 725 µm.

A titre d'exemple, le substrat 21 n'est pas dopé ou est très peu dopé. La concentration en dopants dans le substrat 21 est, par exemple, inférieure à environ 10¹² atomes/cm³ pour des atomes de phosphore et, par exemple, inférieure à environ 4.10¹² atomes/cm³ pour des atomes de bore. A titre d'exemple, les dopants présents dans le substrat 21 peuvent être différents du phosphore et du bore et peuvent être de l'arsenic ou de l'antimoine.

La figure 3 illustre la structure obtenue à l'issue d'une étape de formation d'une couche isolante 23 du côté de la face supérieure du substrat 21.

A titre d'exemple, la couche 23 est une couche d'oxyde.

Dans l'exemple illustré en figure 3, une partie supérieure du substrat 21 est oxydée de façon à former la couche 23. La couche 23 correspond alors à une partie supérieure du substrat 21. La couche 23 est en la même composition chimique que le substrat 21 à la différence près qu'elle comprend une concentration plus importante en atomes d'oxygène. Dans cet exemple, la couche 23 a une épaisseur e1 comprise entre 5 nm et 30 nm, par exemple, comprise entre 15 nm et 20 nm.

A titre d'exemple, la couche 23 est formée par oxydation thermique ou chimique d'une partie supérieure du substrat 21. A titre d'exemple, la couche 23 est formée lors d'un nettoyage de la face supérieure du substrat 21 dans un mélange d'acide sulfurique et d'eau oxygénée. A titre de variante, la couche 23 est une couche d'oxyde natif présente en surface du substrat 21.

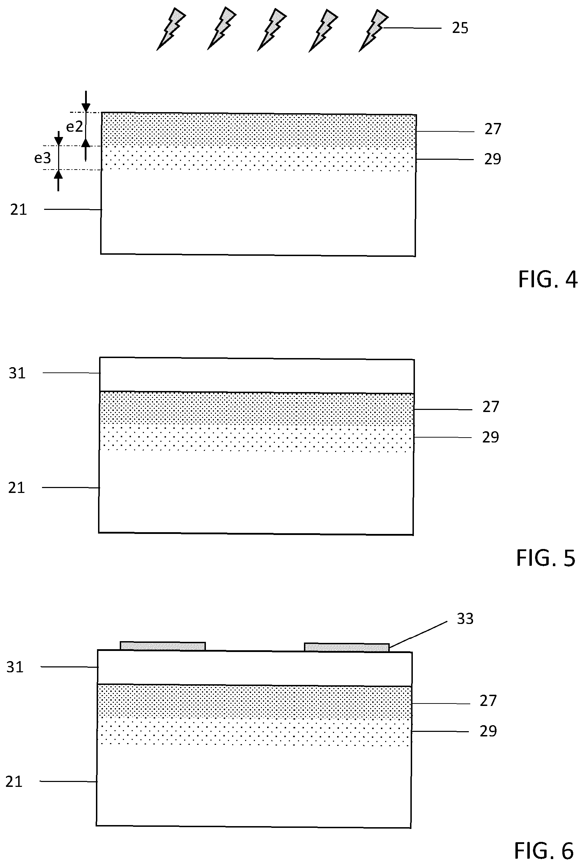

La figure 4 illustre la structure obtenue à l'issue d'une étape de recuit laser à partir de la face supérieure de la structure illustrée en figure 3.

L'étape de recuit laser illustrée en relation avec la figure 3 comprend deux étapes successives.

Lors d'une première étape, la surface supérieure de la structure est exposée au rayonnement d'un laser 25, par exemple un laser pulsé. La
surface supérieure de la structure est exposée aux rayonnements du laser 25 jusqu'à faire fondre une partie supérieure du matériau semiconducteur du substrat 21. On désigne par la référence 27 une couche supérieure de la structure d'épaisseur e2, fondue sous l'effet du rayonnement laser. L'épaisseur e2 dépend notamment de la puissance du laser 25, de la longueur d'onde du laser 25, du matériau du substrat 21, et, le cas échéant, de la durée et de la fréquence des pulsations du laser 25. A titre d'exemple, la puissance du laser 25 est de l'ordre de 4 J/cm². La longueur d'onde du laser 25 peut être choisie en fonction du matériau du substrat 21. Elle est par exemple comprise entre 300 nm et 700 nm. A titre d'exemple, pour un substrat 21 en silicium, la longueur d'onde du laser 25 peut être inférieure à 500 nm, et, pour un substrat 21 en nitrure de gallium, la longueur d'onde du laser 25 peut être inférieure à 400 nm. L'épaisseur e2 est par exemple comprise entre 0,5 µm et 2 µm, par exemple de l'ordre de 1 µm. A titre d'exemple, lors de cette première étape, les atomes d'oxygène présents dans la couche d'oxyde 23 diffusent dans la couche 27, on dit alors que la couche 23 est une source d'atomes d'oxygène qui diffusent dans la couche 27. La couche 27 comprend donc une concentration en atomes d'oxygène supérieure à la concentration en atomes d'oxygène dans la partie inférieure du substrat 21.

Lors d'une deuxième étape, la structure et plus particulièrement la couche supérieure 27 de la structure est refroidie, de préférence rapidement. La vitesse de refroidissement est supérieure à la vitesse de cristallisation du matériau du substrat 21 de sorte que la couche 27 ne recristallise pas et reste dans un état amorphe.

A l'issue de l'étape de recuit laser, le substrat 21 présente, dans sa partie supérieure 27, des défauts résultant de l'incorporation d'atomes d'oxygène (en provenance notamment de la couche d'oxyde 23 et de l'atmosphère de la chambre de recuit) et de carbone (en provenance de l'atmosphère de la chambre de recuit) dans le matériau du substrat. A titre d'exemple, dans le cas d'un substrat en silicium, les défauts formés dans la couche 27 sont sous la forme de complexes entre des atomes de carbone et des atomes de silicium et de complexes entre des atomes de carbone et des atomes d'oxygène. Ces défauts sont adaptés à piéger d'éventuels porteurs de charge présents dans la couche 27.

La densité de défauts générés dans la partie supérieure 27 du substrat 21 lors de l'étape de recuit dépend notamment de la vitesse de chauffe et de la vitesse de refroidissement du substrat 21. En particulier, plus la vitesse de chauffe est importante et plus rapide est le refroidissement, plus grande sera la densité en défauts.

Lors de l'étape de recuit laser, une autre couche 29 du substrat 21, située sous et en contact avec la couche fondue 27, subit également des transformations. En particulier, lors du refroidissement, des défauts de structure cristalline de la structure ont tendance à se propager dans l'épaisseur du substrat 21 sous la couche 27. A la différence de la couche 27, la couche 29 du substrat 21 ne fond pas et reste cristalline. La couche 29 s'étend dans le substrat 21 à partir de la face inférieure de la partie 27 sur une épaisseur e3. A titre d'exemple, l'épaisseur e3 est comprise entre 0,5 µm et 2 µm, par exemple de l'ordre de 1 µm. La couche 29 contient des défauts de type vides ("voids" ou "gaps" en anglais), adaptés à piéger d'éventuels porteurs de charge présents dans la couche 29.

A titre d'exemple, l'étape de recuit laser mentionnée ci-avant est réalisée pleine plaque, c'est à dire qu'elle est réalisée sur toute la surface du substrat 21.

En variante, l'étape de recuit laser mentionnée ci-avant est réalisée localement à la surface du substrat 21. Dans cette variante, la précision ou résolution du laser est, par exemple, de l'ordre de quelques micromètres.

Dans l'exemple illustré en figure 4, l'étape de recuit laser n'engendre pas de texturation de la surface du substrat 21. Autrement dit, la face supérieure du substrat 21, et plus particulièrement la face supérieure de la couche 27 est plane à l'issue de l'étape de recuit laser.

La figure 5 illustre la structure obtenue à l'issue d'une étape de dépôt d'une couche isolante électriquement ou couche de passivation 31 à la surface de la structure illustrée en figure 4.

A titre d'exemple, la couche 31 est en un oxyde, par exemple du dioxyde de silicium.

A titre d'exemple, la couche 31 est déposée pleine plaque à la surface du dispositif illustré en figure 4, c'est-à-dire qu'elle est déposée de façon à recouvrir intégralement la face supérieure du substrat 21. A titre d'exemple, la couche 31 a une épaisseur comprise entre 0,5 µm et 2 µm, par exemple de l'ordre de 1,2 µm.

La figure 6 illustre le dispositif obtenu à l'issue d'une étape de formation de composants radiofréquence 33 sur la couche isolante 31.

Dans l'exemple illustré en figure 6, le dispositif comprend deux composants radiofréquence 33. En pratique, le dispositif peut porter un nombre quelconque de composants radiofréquence 33, par exemple, un unique composant radiofréquence 33 ou plus de deux composants radiofréquence 33.

A titre d'exemple, les composants radiofréquence 33 sont des composants passifs, par exemple des inductances ou des antennes. Les composants radiofréquence 33 sont par exemple en un matériau métallique, par exemple du cuivre ou de l'aluminium.

A titre d'exemple, les composants radiofréquence 33 sont configurés pour fonctionner dans une plage de fréquence comprise entre quelques Kilohertz et quelques Gigahertz, par exemple entre 3 kHz et 30 GHz.

Un avantage du procédé décrit en relation avec les figures 2 à 6 est qu'il permet, par une technique de recuit laser relativement simple à mettre en oeuvre, de réaliser une couche superficielle riche en pièges dans un substrat semiconducteur destiné à supporter des composants radiofréquence. La méthode proposée permet, à faible coût, d'obtenir une densité de pièges importante, et ainsi de réduire significativement les courants parasites induits dans le substrat et donc d'améliorer les performances des composants radiofréquence.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, les modes de réalisation décrits ne se limitent pas aux exemples de matériaux et de dimensions mentionnés dans la présente description.

En outre, bien que l'on ait détaillé ci-dessus uniquement des exemples de substrats à haute résistivité, les modes de réalisation décrits ne se limitent pas à ce cas particulier.

Enfin, la mise en oeuvre pratique des modes de réalisation et variantes décrits est à la portée de la personne du métier à partir des indications fonctionnelles données ci-dessus.

## Revendications

1. Procédé de fabrication d'un dispositif comportant au moins un composant radiofréquence (33) sur un substrat semiconducteur (21) comprenant les étapes successives suivantes :
a) un recuit laser d'une première épaisseur (27) du substrat du côté de la face supérieure du substrat, résultant en la formation d'une couche riche en piège dans une portion supérieure du substrat ;
b) la formation d'une couche isolante (31) sur la face supérieure du substrat ; et
c) la formation dudit au moins un composant radiofréquence sur la couche isolante,
dans lequel, à l'étape a), le recuit laser comprend une exposition du substrat au laser jusqu'à faire fondre la première épaisseur (27) du substrat, suivie d'une étape de refroidissement à une vitesse de refroidissement supérieure à la vitesse de cristallisation du matériau du substrat de sorte que la première épaisseur (27) reste dans un état amorphe.

2. Procédé selon la revendication 1, dans lequel le substrat (21) a une résistivité supérieure à 3 kΩ.cm.

3. Procédé selon la revendication 1 ou 2, comprenant, avant l'étape a), une étape de formation d'une couche d'oxyde (23) du côté de la face supérieure du substrat (21).

4. Procédé selon l'une quelconque des revendications 1 à 3, dans lequel la puissance du laser lors de l'étape a) est de l'ordre de 4j/cm².

5. Procédé selon l'une quelconque des revendications 1 à 4, dans lequel le substrat (21) est en silicium ou en nitrure de gallium.

6. Procédé selon l'une quelconque des revendications 1 à 5, dans lequel le laser a une longueur d'onde comprise entre 300 nm et 700 nm.

7. Procédé selon l'une quelconque des revendications 1 à 6, dans lequel la première épaisseur (27) est comprise entre 0,5 µm et 2 µm, par exemple, de l'ordre de 1 µm.

8. Procédé selon l'une quelconque des revendications 1 à 7, dans lequel ledit au moins un composant radiofréquence est un composant passif en un matériau métallique disposé sur et en contact avec la face supérieure de la couche isolante (31) .

## Patentansprüche

1. Verfahren zur Herstellung einer Einrichtung, die wenigstens eine Hochfrequenz-Komponente (33) auf einem Halbleiter-Substrat (21) aufweist, das Folgendes aufweist, in den folgenden aufeinanderfolgenden Schritten:
a) Laser-Tempern einer ersten Dicke (27) des Substrats auf der Seite einer oberen Fläche des Substrats, das zur Ausbildung einer trap-reichen Schicht in einem oberen Abschnitt des Substrats führt;
b) Ausbilden einer Isolierschicht (31) auf der oberen Fläche des Substrats; und
c) Ausbilden der wenigstens einen Hochfrequenz-Komponente auf der Isolierschicht,
wobei während Schritt a) das Laser-Tempern das Aussetzen des Substrats gegenüber dem Laser umfasst, bis die erste Dicke (27) des Substrats schmilzt, gefolgt von einem Schritt des Abkühlens mit einer Abkühlrate, die die Kristallisationsrate des Substratmaterials übersteigt, so dass die erste Dicke (27) in einem amorphen Zustand verbleibt.

2. Verfahren nach Anspruch 1, wobei das Substrat (21) einen spezifischen Widerstand von mehr als 3 kΩ aufweist.

3. Verfahren nach Anspruch 1 oder 2, das vor Schritt a) einen Schritt des Ausbildens einer Oxidschicht (23) auf der Seite der oberen Fläche des Substrats (21) aufweist.

4. Verfahren nach einem der Ansprüche 1 bis 3, wobei die Leistung des Lasers während Schritt a) in der Größenordnung von 4 J/cm² liegt.

5. Verfahren nach einem der Ansprüche 1 bis 4, wobei das Substrat (21) aus Silizium oder aus Galliumnitrid besteht.

6. Verfahren nach einem der Ansprüche 1 bis 5, wobei der Laser eine Wellenlänge im Bereich von 300 nm bis 700 nm aufweist.

7. Verfahren nach einem der Ansprüche 1 bis 6, wobei die erste Dicke (27) im Bereich von 0,5 µm bis 2 µm liegt, beispielsweise in der Größenordnung von 1 µm.

8. Verfahren nach einem der Ansprüche 1 bis 7, wobei die wenigstens eine Hochfrequenz-Komponente eine passive Komponente aus einem metallischen Material ist, die auf der oberen Fläche der Isolierschicht (31) aufgelegt und in Kontakt mit dieser ist.

## Claims

1. Method of manufacturing a device comprising at least one radio frequency component (33) on a semiconductor substrate (21) comprising the following successive steps:
a) a laser anneal of a first thickness (27) of the substrate on the upper surface side of the substrate, resulting in the formation of a trap-rich layer in the upper portion of the substrate;
b) the forming of an insulating layer (31) on the upper surface of the substrate; and
c) the forming of said at least one radio frequency component on the insulating layer,
wherein, during step a), the laser annealing comprises exposing the substrate to the laser until the first thickness (27) of the substrate melts, followed by a step of cooling at a cooling rate that exceeds the crystallization rate of the substrate material, so that the first thickness (27) remains in an amorphous state.

2. Method according to claim 1, wherein the substrate (21) has a resistivity greater than 3 kΩ.

3. Method according to claim 1 or 2, comprising, before step a), a step of forming of an oxide layer (23) on the upper surface side of the substrate (21).

4. Method according to any of claims 1 to 3, wherein the power of the laser during step a) is in the order of 4 J/cm².

5. Method according to any of claims 1 to 4, wherein the substrate (21) is made of silicon or of gallium nitride.

6. Method according to any of claims 1 to 5, wherein the laser has a wavelength in the range from 300 nm to 700 nm.

7. Method according to any of claims 1 to 6, wherein the first thickness (27) is in the range from 0.5 µm to 2 µm, for example, in the order of 1 µm.

8. Method according to any of claims 1 to 7, wherein the at least one radio frequency component is a passive component made of a metallic material that is placed on an in contact with the upper face of the insulating layer (31).
